# FASCICULE DE BREVET EUROPEEN

(11) **EP 0 523 590 B1**
(45) Date de publication et mention de la délivrance du brevet: **27.12.1995**
(21) Numéro de dépôt: 92111890.7
(22) Date de dépôt: 13.07.1992
(51) Int. Cl.: H01L 31/08, H01L 51/20

(54) **Convertisseur opto-électronique**
Optoelektronischer Wandler
Optoelectronic converter

(30) Priorité: 19.07.1991 FR 9109175
(43) Date de publication de la demande: 20.01.1993
(73) Titulaire: ALCATEL ALSTHOM COMPAGNIE GENERALE D'ELECTRICITE, 74382 Paris Cédex 08 (FR)
(72) Inventeur: Le Mehaute, Alain, F-91190 Gif sur Yvette (FR); Joachim, Christian, F-31870 Lagardelle sur Leze (FR)
(74) Mandataire: Weinmiller, Jürgen

(56) Documents cités:
- GB-A- 1 586 458
- US-A- 4 695 733
- PATENT ABSTRACTS OF JAPAN vol. 11, no. 17 (E-471)(2464) 17 Janvier 1987
- OPTICS COMMUNICATIONS. vol. 32, no. 3, Mars 1980, AMSTERDAM NL pages 485 - 488 P.S.MAK ET AL. 'PICOSECOND OPTOELECTRONIC SWITCHING IN CdS0.5Se0.5'
- PATENT ABSTRACTS OF JAPAN vol. 9, no. 62 (P-342)19 Mars 1985
- PHYSICS TODAY. Février 1990, NEW YORK US pages 24 - 30 H.I.SMITH ET AL. 'NANOFABRICATION'

## Description

La présente invention concerne un convertisseur opto-électronique destiné notamment à être utilisé comme composant de base dans des systèmes de communication et de traitement de l'information à très haut degré d'intégration.

On appelle convertisseur opto-électronique un composant présentant une impédance électromagnétique variable en fonction de l'énergie optique ou du champ électrique statique qu'il reçoit.

A l'heure actuelle les composants les plus petits de ce genre (10 nm environ) comportent un matériau à réponse non linéaire, par exemple de type semi-conducteur II/VI tel que CdS, CdSₓ Se₁₋ₓ, enfermé dans des billes de verre dont la variation de couleur est due à la fois à la variation de la composition et au confinement quantique. Ces matériaux présentent le défaut de n'être pas très stables dans le temps.

Les mêmes matériaux ou des matériaux semi-conducteurs de type III/V, tels que InGaAs, présentant le même type de propriétés, peuvent être optimisés dans des systèmes de taille millimétrique.

Par ailleurs on sait que les propriétés non linéaires peuvent être augmentées par abaissement de la dimensionnalité, comme indiqué dans les articles parus dans J. opt. Soc. Am.B2 (1985) 1155 et Phys. Rev. B36 (1987) 9293. Toutefois ces systèmes conservent encore une dimension de l'ordre de plusieurs millimètres.

La présente invention a pour but de réaliser un convertisseur opto-électronique dont les dimensions soient de l'ordre du nanomètre.

La présente invention a pour objet un convertisseur opto-électronique, caractérisé par le fait qu'il comprend une cavité résonante mésoscopique constituée par un fil quantique, en matériau conducteur ou semi-conducteur, situé entre deux miroirs électroniques de taille nanométrique, ledit fil étant coupé sur un intervalle de l'ordre de quelques nanomètres, intervalle dans lequel est inséré un matériau photosensible, des plots étant prévus aux extrémités de ladite cavité pour permettre le passage d'un courant électrique.

On entend par cavité résonante mésoscopique une cavité résonante de taille nanométrique.

Le principe de fonctionnement de cette cavité est la modulation de l'impédance de la ligne électronique quantique au moyen d'une onde optique dont l'objet est de modifier les niveaux d'énergie accessibles sur la molécule du matériau photosensible.

On entend par matériau photosensible un photosensibilisateur tel que la rhodamine B, un colorant tel que les molécules azoïques ou les cyanines, les thiazoles, les xanthènes, les semi-conducteurs de type II-VI ou III-V déjà évoqués plus haut.

Les photons absorbés dans le matériau photosensible modifient la conductivité de la cavité.

Selon un mode de réalisation, ledit fil quantique présente :
- une longueur comprise entre 10 nm et 500 nm,
- une largeur comprise entre 2 nm et 50 nm,
- une épaisseur comprise entre 0,2 nm et 1 nm.

La largeur dudit intervalle peut être comprise entre 0,5 nm et 10 nm.

Le courant susceptible d'être appliqué dans ledit fil quantique est compris entre 10⁻⁸ et 10⁻¹⁶ ampère.

Le matériau dudit fil quantique peut être choisi parmi l'or, l'argent, le cuivre, le platine, l'alliage or-palladium, ou tout autre métal noble ; ce peut être également un semi-conducteur dopé tel que le silicium ou l'AsGa dopé, ou un polymère conducteur électronique.

Le miroir électronique est élaboré par création d'une rupture d'impédance aux extrémités du fil :
- par un changement de matériau, par exemple un passage cuivre/or ou AsGa/Pt;
- par un simple gap de faible largeur, telle que 0,1 nanomètre (1 Ångström).

L'énergie optique envoyée sur le matériau photosensible est extrêmement faible. Elle est de l'ordre d'une fraction de picojoule. Cette énergie est suffisante pour faire varier l'impédance de la cavité entre lesdits plots.

L'énergie dissipée dans le convertisseur selon l'invention étant également extrêmement faible, il peut être utilisé sans inconvénient à très basse température.

Le convertisseur selon l'invention peut être réalisé sur un support isolant en silice, ou en silicium, par les techniques de nanolithographie connues. De telles techniques sont décrites en particulier dans les articles suivants :
[1] "Nanofabrication" par H.I. Smith et al - PHYSICS TODAY - February 1990, p. 24 à 30.
[2] "Nanolithography with a high resolution STEM" par C.P. Umbach et al - IBM J. Res. Develop. Vol 32 n° 4 July 1988 p. 454 à 461.
[3] "Nanostructure technology" par T.H.P. Chang et al - IBM J. Res. Develop. vol 32 n° 4 July 1988, p.462 à 487.
[4] "Resolution limits for electron-beam lithography" par A.N. BROERS - IBM J. Res. Develop. vol.32 n° 4 July 1988 p. 502 à 512.

D'autres caractéristiques et avantages de la présente invention apparaîtront au cours de la description suivante d'un mode de réalisation donné à titre illustratif mais nullement limitatif. Dans le dessin annexé :
- La figure 1 est une vue de dessus très schématique d'un convertisseur opto-électronique selon l'invention.
- La figure 2 montre les variations de l'admittance d'une cavité selon l'invention en fonction de l'onde optique incidente.

On part d'un support 1 à base de silice tel qu'une membrane en SiN₄ d'épaisseur 100 nm (1.000 Å). On y réalise par une technique de nanolithographie une cavité mésoscopique 2 en métal noble, tel que l'or- palladium. Cette cavité est constituée d'un fil quantique 3 ayant une longueur de 500 nm, une largeur de 30 nm et une épaisseur de 1 nm ; elle est fermée par deux miroirs 4 et 5 en cuivre qui prolongent le fil 3. Deux plots 6 et 7 en or ou en argent sont prévus pour amener du courant dans la cavité 2.

Par bombardement électronique sous 300 Kvolts on coupe le fil quantique 3 sur une distance 8 de l'ordre de 5 nm. On insère dans l'intervalle ainsi formé un matériau 9 tel que de la rhodamine B photosensible. La méthode consiste à mettre ce matériau en solution dans un solvant puis à imprégner et à laisser sécher. Un tel matériau est sensible à un rayonnement optique de longueur d'onde comprise entre 0,3 »m et 0,8 »m, avec une énergie de 10⁻³ picojoule.

On utilisera préférentiellement le styril 9 pour des absorptions autour de 700 nm, la rhodamine B pour 590 nm, la rhodamine 66 pour 530 nm, la coumarine 6 pour 500 nm, la coumarine 102 pour 450 nm, le stylbène 3 pour 400 nm.

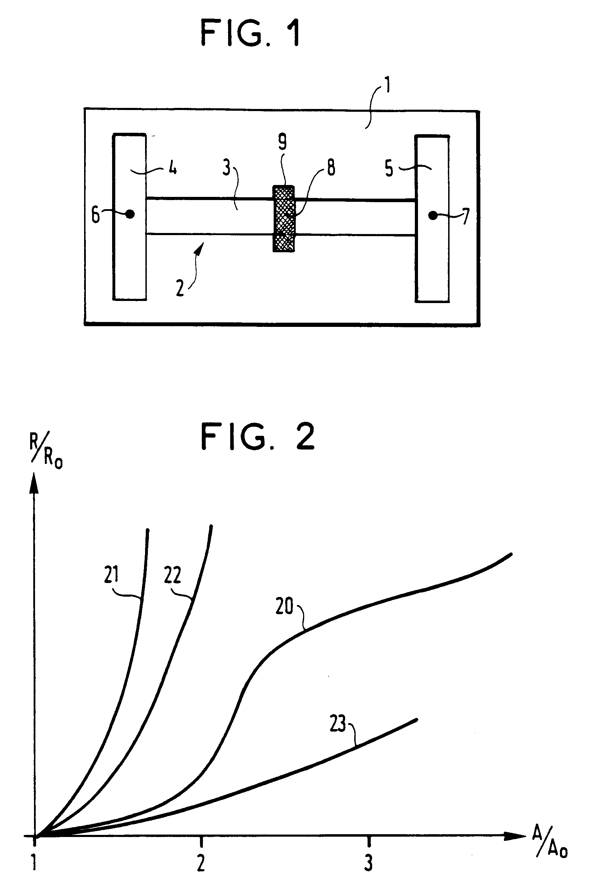

Lorsque l'on amène un courant alternatif ou continu par les plots 6 et 7 dans la cavité selon l'invention, toute modification de l'éclairement des molécules photosensibles va induire une modification de l'impédance donc de la transmittance de la cavité, effet qui va avoir une conséquence sur le rapport courant/tension. Il y aura donc détection électrique d'une propriété optique comme le montre la figure 2. On a reporté dans cette figure :
- En abscisses, le rapport A/Aₒ correspondant à l'amplitude normalisée de l'onde optique incidente.
- En ordonnées, le rapport R/Rₒ correspondant à l'admittance normalisée de la cavité.

La courbe 20 correspond à un intervalle 8 de 5 nm, tandis que les courbes 21, 22, 23 correspondent respectivement à des cavités de même nature mais avec un intervalle 8 de largeur 1 nm, 1,5 nm, 10 nm.

Selon un autre mode de réalisation, on se sert d'une tête de microscope tunnel pour venir positionner un certain nombre de molécules de rhodamine B dans l'intervalle 8. (Cette méthode très précise a en outre pour avantage de pouvoir disposer sur plusieurs cavités connectées en série ou en parallèle des molécules photosensibles distinctes susceptibles d'être sensibles à des longueurs d'onde différentes).

Compte tenu des dimensions du convertisseur opto-électronique selon l'invention, il est possible d'en intégrer plus de 100.000 sur un support de 1 mm².

Bien entendu, on peut remplacer par d'autres matériaux les matériaux de la cavité qui vient d'être décrite.

Ainsi, le support 1 peut être en GaAs recouvert d'une membrane en AlGaAs non dopé, d'épaisseur 100 nm. On sait doper AlGaAs avec de l'indium ou du phosphore suivant un fil présentant les dimensions indiquées plus haut. Les miroirs sont en platine et les reprises de courant sont en or ou en argent.

Selon encore une autre variante, la membrane est en AlGaAs dopé et le fil de la cavité en AlGaAs non dopé. Toute autre disposition équivalente peut être envisagée.

## Revendications

1. Convertisseur opto-électronique, caractérisé par le fait qu'il comprend une cavité résonante mésoscopique (2) constituée par un fil quantique (3), en matériau conducteur ou semi-conducteur, situé entre deux miroirs électroniques (4,5) de taille nanométrique, ledit fil étant coupé sur un intervalle (8) de l'ordre de quelques nanomètres, intervalle dans lequel est inséré un matériau photosensible (9), des plots (6,7) étant prévus aux extrémités de ladite cavité pour permettre le passage d'un courant électrique.

2. Convertisseur opto-électronique selon la revendication 1, caractérisé par le fait que ledit fil quantique présente :
- une longueur comprise entre 10 nm et 500 nm,
- une largeur comprise entre 2 nm et 50 nm,
- une épaisseur comprise entre 0,2 nm et 1 nm.

3. Convertisseur opto-électronique selon la revendication 2, caractérisé par le fait que ledit intervalle a une largeur comprise entre 0,5 nm et 10 nm.

4. Convertisseur opto-électronique selon l'une des revendications 1 à 3, caractérisé par le fait que ledit courant susceptible d'être appliqué dans ledit fil quantique est compris entre 10⁻⁸ et 10⁻¹⁶ Ampère.

5. Convertisseur opto-électronique selon l'une des revendications précédentes, caractérisé par le fait que le matériau dudit fil quantique est choisi parmi l'or, l'argent, le cuivre, le platine, un alliage or-palladium.

6. Convertisseur opto-électronique selon l'une des revendications 1 à 4, caractérisé par le fait que le matériau dudit fil quantique est choisi parmi un semi-conducteur dopé, et un polymère conducteur électronique.

7. Convertisseur opto-électronique selon l'une des revendications précédentes, caractérisé par le fait que ledit matériau photosensible est choisi parmi un photosensibilisateur tel que la rhodamine B, un colorant tel que les molécules azoïques et les cyanines, les thiazoles, les xanthènes.

8. Convertisseur opto-électronique selon l'une des revendications 1 à 6, caractérisé par le fait que ledit matériau photosensible est choisi parmi les semi-conducteurs II-VI, tels que CdS, CdSₓ Se₁₋ₓ, et les semi-conducteurs III-V tels que InGaAs.

9. Convertisseur opto-électronique selon l'une des revendications précédentes, caractérisé par le fait que lesdits miroirs électroniques sont réalisés par un changement de matériau aux extrémités du fil définissant ainsi une rupture d'impédance.

10. Convertisseur opto-électronique selon l'une des revendications 1 à 8, caractérisé par le fait que lesdits miroirs électroniques sont réalisés par simple coupure du fil sur une distance de l'ordre de 0,1 nanomètre, définissant ainsi une rupture d'impédance.

## Patentansprüche

1. Opto-elektronischer Wandler, dadurch gekennzeichnet, daß er einen mesoskopischen Resonanzhohlraum (2) aufweist, der aus einem Quantenfaden (3) aus leitendem oder halbleitendem Material besteht und sich zwischen zwei elektronischen Spiegeln (4, 5) von nanometrischer Größe befindet, wobei der Faden über eine Länge (8) von einigen Nanometern unterbrochen ist und an seiner Statt ein lichtempfindliches Material (9) eingefügt ist, und daß Leitflecke (6, 7) an den Enden des Hohlraums vorgesehen sind, um den Durchlaß eines elektrischen Stroms zu erlauben.

2. Opto-elektronischer Wandler nach Anspruch 1, dadurch gekennzeichnet, daß der Quantenfaden aufweist:
- eine Länge zwischen 10 nm und 500 nm
- eine Breite zwischen 2 nm und 50 nm
- eine Dicke zwischen 0,2 nm und 1 nm.

3. Opto-elektronischer Wandler nach Anspruch 2, dadurch gekennzeichnet, daß die Länge der Unterbrechung zwischen 0,5 nm und 10 nm liegt.

4. Opto-elektronischer Wandler nach einem der Ansprüche 1 bis 3, dadurch gekennzeichnet, daß der an den Quantenfaden anlegbare Strom zwischen 10⁻⁸ und 10⁻¹⁶ Ampère liegt.

5. Opto-elektronischer Wandler nach einem der vorhergehenden Ansprüche, dadurch gekennzeichnet, daß das Material des Quantenfadens ausgewählt wird aus Gold, Silber, Kupfer, Platin oder einer Gold-Palladium-Legierung.

6. Opto-elektronischer Wandler nach einem der Ansprüche 1 bis 4, dadurch gekennzeichnet, daß das Material des Quantenfadens ausgewählt wird aus einem dotierten Halbleiter oder einem elektronisch leitenden Polymer.

7. Opto-elektronischer Wandler nach einem der vorhergehenden Ansprüche, dadurch gekennzeichnet, daß das lichtempfindliche Material ausgewählt wird aus einem Photosensibilisator wie z.B. Rhodamin B, einem Farbgeber wie die Azomoleküle oder Cyanine, Thiazole, Xanthene.

8. Opto-elektronischer Wandler nach einem der Ansprüche 1 bis 6, dadurch gekennzeichnet, daß das lichtempfindliche Material ausgewählt wird unter den Halbleitern des Typs II/VI wie z.B. CdS, CdSₓ Se₁₋ₓ, und den Halbleitern des Typs III-V, z.B. InGaAs.

9. Opto-elektronischer Wandler nach einem der vorhergehenden Ansprüche, dadurch gekennzeichnet, daß die elektronischen Spiegel hergestellt werden durch eine Materialänderung am Ende des Fadens, wodurch eine Impedanzunterbrechung definiert wird.

10. Opto-elektronischer Wandler nach einem der Ansprüche 1 bis 8, dadurch gekennzeichnet, daß die elektronischen Spiegel hergestellt werden durch ein einfaches Unterbrechen des Fadens über eine Länge der Größenordnung von 0,1 Nanometer, wodurch eine Impedanzunterbrechung definiert wird.

## Claims

1. An opto-electronic converter characterized by the fact that it comprises a mesoscopic resonant cavity (2) constituted by a quantum wire (3) made of a material that is a conductor or a semiconductor and situated between two electron mirrors (4, 5) of nanometer size, the said wire being interrupted over a gap (8) having a width of a few nanometers, into which gap a photosensitive material (9) is inserted, tabs (6, 7) being provided at the ends of said cavity to pass an electrical current.

2. An opto-electronic converter according to claim 1, characterized by the fact that said quantum wire has:
a length lying in the range 10 nm to 500 nm;
a width lying in the range 2 nm to 50 nm; and
a thickness lying in the range 0.2 nm to 1 nm.

3. An opto-electronic converter according to claim 2, characterized by the fact that said gap has a width lying in the range 0.5 nm to 10 nm.

4. An opto-electronic converter according to any one of claims 1 to 3, characterized by the fact that said current suitable for being applied to said quantum wire lies in the range 10⁻⁸ A to 10⁻¹⁶ A.

5. An opto-electronic converter according to any preceding claim, characterized by the fact that the material of said quantum wire is selected from: gold, silver, copper, platinum, and a gold-palladium alloy.

6. An opto-electronic converter according to any one of claims 1 to 4, characterized by the fact that the material of said quantum wire is selected from: a doped semiconductor, and an electron-conducting polymer.

7. An opto-electronic converter according to any preceding claim, characterized by the fact that said photosensitive material is selected from: a photosensitizer such as rhodamine B, a dye such as azo molecules and cyanines, thiazoles, xanthenes.

8. An opto-electronic converter according to any one of claims 1 to 6, characterized by the fact that said photosensitive material is selected from II-VI semiconductors such as CdS, CdSₓ Se₁₋ₓ, and III-V semiconductors such as InGaAs.

9. An opto-electronic converter according to any preceding claim, characterized by the fact that said electron mirrors are made by changing the material at the ends of the wire, thereby defining an impedance break.

10. An opto-electronic converter according to any one of claims 1 to 8, characterized by the fact that said electron mirrors are constituted merely by interrupting the wire over a distance of the order of 0.1 nanometer, thereby defining an impedance break.
